# EUROPEAN PATENT APPLICATION

(11) **EP 4 625 611 A1**
(43) Date of publication of application: **01.10.2025**
(21) Application number: 25161879.9
(22) Date of filing: 05.03.2025
(51) Int. Cl.: H01M 10/48, H01M 50/583, H02J 7/00

(54) **APPARATUS FOR MONITORING BATTERY STATUS, BATTERY MANAGEMENT SYSTEM, AND IGNITION CIRCUIT FOR BATTERY MANAGEMENT SYSTEM**

(30) Priority: 26.03.2024 KR 20240040929
(71) Applicant: SAMSUNG SDI CO., LTD., Yongin-si, Gyeonggi-do 17084 (KR)
(72) Inventor: KIM, HYUN, 16678 Suwon-si, Gyeonggi-do (KR)
(74) Representative: Gulde & Partner

(57) **Abstract**

An apparatus for monitoring a battery status, a battery management system (BMS), and an ignition circuit for the battery management system provide a circuit topology capable of monitoring a status of a battery device at all times irrespective of an enabled or disabled state of the BMS. In a specific configuration, based on a structure in which a thermal fuse is provided in a battery device, according to a battery status monitoring signal generated according to a status of a thermal fuse block, an electrical connection of the battery device to a power supply block inside a BMS is enabled or disabled, and/or an operation trigger for the power supply block is controlled.

## Description

### BACKGROUND

### 1. Field

The present disclosure relates to a technology for monitoring a status of a battery device.

### 2. Description of the Related Art

Unlike a primary battery that cannot be recharged, a secondary battery is a battery that can be charged and discharged. Low-capacity secondary batteries are used in small portable electronic devices such as smartphones, feature phones, laptop computers, digital cameras, and camcorders. High-capacity secondary batteries are widely used as driving power sources and power storage batteries for motors in hybrid vehicles, electric vehicles, and the like. Such a secondary battery includes an electrode assembly including a positive electrode and a negative electrode, a case for accommodating the same, and an electrode terminal connected to the electrode assembly.

The above information described in the background section of the present disclosure is merely disclosed for helping to understand the background technology of the present disclosure, and therefore, it may contain information that does not constitute related (or prior) art.

### SUMMARY

The invention is defined by the appended claims. The description that follows is subjected to this limitation. Any disclosure lying outside the scope of said claims is only intended for illustrative as well as comparative purposes.

The present disclosure is directed to provide an apparatus for monitoring a battery status, which is capable of monitoring a status of a battery device at all times irrespective of an enabled or disabled state of a battery management system (BMS), which is a system that monitors a status of the battery device, a battery management system, and an ignition circuit for the battery management system.

However, objects that the present disclosure intends to achieve are not limited to the above-described objects and other objects that are not described may be clearly understood by those skilled in the art from the following description.

According to an aspect of the present disclosure, there is provided an apparatus for monitoring a battery status, the apparatus including an ignition block configured to enable or disable an electrical connection between a battery device and a power supply block mounted in a vehicle, the power supply block supplies operating power for managing the battery device to a processor based on battery power applied from the battery device, and a thermal fuse block including one or more thermal fuses provided in the battery device, wherein, according to a status monitoring signal for the battery device generated according to a status of the thermal fuse block, the ignition block operates (i) to enable or disable the electrical connection between the battery device and the power supply block and/or (ii) to control an operation trigger for the power supply block.

According to another aspect of the present disclosure, an ignition circuit for a battery management system is provided, with the ignition circuit including a main switch configured to enable or disable an electrical connection between a battery device and a power supply block mounted in a vehicle; and a sub-switch configured to selectively connect a control terminal for controlling an on/off operation of the main switch to a first node and a second node, wherein the first node is a node connected to a thermal fuse block including one or more thermal fuses provided in the battery device, and the second node is a node connected to a high-level controller applied to the vehicle. In a state in which a trigger signal is not applied from the high-level controller through the second node, the sub-switch is configured to connect the control terminal to the first node.

According to another aspect of the present disclosure, a battery management system for managing a battery device provided with a thermal fuse block including one or more thermal fuses is provided. The battery management system includes a power supply block configured to supply power for enabling the battery management system based on battery power applied from the battery device; an ignition block that, according to a status monitoring signal for the battery device generated according to a status of the thermal fuse block, is configured to (i) enable or disable an electrical connection between the battery device and the power supply block and/or (ii) to control an operation trigger for the power supply block; and a processor that, in a state in which the battery device and the power supply block are electrically connected by the ignition block, is enabled by receiving operating power from the power supply block and monitors a status of the battery device.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 illustrates a battery module according to one embodiment of the present disclosure;
FIGS. 2A and 2B illustrate a battery pack according to one embodiment of the present disclosure;
FIG. 3 is a block diagram of an apparatus for monitoring a battery status according to one embodiment of the present disclosure;
FIG. 4 illustrates an exemplary wiring structure of a thermal fuse block according to one embodiment of the present disclosure; and
FIGS. 5 and 6 illustrate an exemplary circuit of an ignition block according to one embodiment of the present disclosure.

### DETAILED DESCRIPTION

Hereinafter, embodiments of the present disclosure will be described in detail with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc., may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

According to one aspect of the invention, an apparatus for monitoring a battery status, is provided. The apparatus for monitoring a battery status includes an ignition block configured to enable or disable an electrical connection between a battery device and a power supply block mounted in a vehicle, wherein the power supply block supplies operating power for managing the battery device to a processor based on battery power applied from the battery device and a thermal fuse block including one or more thermal fuses provided in the battery device, wherein the ignition block operates to enable or disable the electrical connection between the battery device and the power supply block and/or control an operation trigger for the power supply block according to a status monitoring signal for the battery device generated according to a status of the thermal fuse block.

In other words, the apparatus comprises a thermal fuse block including one or more thermal fuses provided in the battery device, wherein, according to a status monitoring signal for the battery device generated according to a status of the thermal fuse block, the ignition block is configured to perform an operation (i) to enable or disable the electrical connection between the battery device and the power supply block and/or (ii) to control the operation trigger for the power supply block. The apparatus may be configured to determine the status monitoring signal based on the status of the thermal fuse block.

According to one embodiment, the battery device may include first to N^{th} battery cells (N is a natural number of 2 or more), the thermal fuse block may include M^{th} to K^{th} thermal fuses respectively provided in the M^{th} to K^{th} battery cells among the first to Nth battery cells (M is a natural number of 1 or more, K is a natural number of N or less, and M≤K), and the M^{th} to K^{th} thermal fuses are connected in series.

According to another embodiment, a signal level of the status monitoring signal may be generated according to a status of a signal path connected from one terminal of the battery device to the M^{th} to K^{th} thermal fuses. In other words, the signal level of status monitoring signal may be based on the status of the signal path.

According to another embodiment, in a state in which the M^{th} to K^{th} thermal fuses are not fused, the status monitoring signal may have a first signal level, and when the status monitoring signal having the first signal level is applied, the ignition block disables the electrical connection between the battery device and the power supply block and/or does not trigger the operation of the power supply block. In other words, not fused M^{th} to K^{th} thermal fuses may cause the first signal level of the status monitoring signal. In other words, the ignition block may be configured to perform the function described above when the first signal level is present.

According to another embodiment, when, or in other words in a state in which, one or more of the M^{th} to K^{th} thermal fuses is fused, the status monitoring signal may have a second signal level, and when the status monitoring signal having the second signal level is applied, the ignition block allows the electrical connection between the battery device and the power supply block and/or triggers an operation of the power supply block. In other words, one or more fused thermal fuses of the M^{th} to K^{th} thermal fuses may cause the second signal level of the status monitoring signal. In other words, the ignition block may be configured to perform the function described above when the second signal level is present.

According to another embodiment, as the battery device and the power supply block are electrically connected so that the power supply block is enabled, when the operating power is supplied to the processor, the processor may determine a status of the battery device according to a predefined state determination logic. In other words, the processor may be configured to perform the function described above when the battery device and the power supply block are electrically connected.

According to another embodiment, in a state in which the electrical connection between the battery device and the power supply block is disabled, in response to a trigger signal applied from a high-level controller applied to the vehicle, the ignition block may allow the electrical connection between the battery device and the power supply block or triggers an operation of the power supply block. In other words, the ignition block may be configured to perform the function described above based on the trigger signal applied from a high-level controller.

According to another embodiment, independently of the trigger signal, according to the status monitoring signal, the ignition block may perform an operation of enabling or disabling the electrical connection between the battery device and the power supply block and/or an operation of controlling the operation trigger for the power supply block. In other words, the ignition block may be configured to perform the function described above independently of the trigger signal.

According to another embodiment, in a state in which an ignition of the vehicle is turned on, that is, in a time section before the trigger signal is applied from a high-level controller, according to the status monitoring signal, the ignition block may enable or disable the electrical connection between the battery device and the power supply block and/or may control the operation trigger for the power supply block, and when the ignition of the vehicle is turned on, in response to the trigger signal applied from the high-level controller, the ignition block may allow the electrical connection between the battery device and the power supply block and/or may triggers the operation of the power supply block. In other words, the ignition block may be configured to perform the function described above.

Yet another aspect of the present disclosure refers to an ignition circuit for a battery management system. The ignition circuit includes a main switch configured to enable or disable an electrical connection between a battery device and a power supply block mounted in a vehicle and a sub-switch configured to selectively connect a control terminal for controlling an on/off operation of the main switch to a first node and a second node, wherein the first node is a node connected to a thermal fuse block including one or more thermal fuses provided in the battery device, and the second node is a node connected to a high-level controller applied to the vehicle. Therein, in a state in which a trigger signal is not applied from the high-level controller through the second node, the sub-switch is configured to connect the control terminal to the first node.

According to one embodiment, in a state in which the control terminal is connected to the first node through the sub-switch, the main switch may receive a status monitoring signal for the battery device, which is generated according to a status of the thermal fuse block, through the control terminal, and according to the received status monitoring signal, the main switch enables or disables the electrical connection between the battery device and the power supply block and/or controls the operation trigger for the power supply block. In other words, the main switch may be configured to receive the status monitoring signal for the battery device and may be configured to, based on the received status monitoring signal, enable or disable the electrical connection between the battery device and the power supply block and/or to control the operation trigger for the power supply block.

According to another embodiment, in a state in which each thermal fuse included in the thermal fuse block is not fused, the status monitoring signal may have a first signal level, and when the status monitoring signal having the first signal level is input through the control terminal, the main switch may disable the electrical connection between the battery device and the power supply block and/or may not trigger the operation of the power supply block. In other words, the main switch may be configured to perform the function described above.

According to another embodiment, in a state in which at least one thermal fuse among the thermal fuses included in the thermal fuse block is fused, the status monitoring signal may have a second signal level, and when the status monitoring signal having the second signal level is input through the control terminal, the main switch may allow the electrical connection between the battery device and the power supply block and/or may trigger the operation of the power supply block. In other words, the main switch may be configured to perform the function described above.

According to another embodiment, the sub-switch may be implemented as a relay including a relay coil of which one terminal is connected to the battery device and a switch element configured to perform a contact switching operation according to excitation of the relay coil. The ignition circuit may include a driving element configured to drive a switching operation of the sub-switch, and the driving element may include a driving terminal connected to the other terminal of the relay coil, a ground terminal connected to a ground, and an input terminal to which the trigger signal is input.

According to another embodiment, as the trigger signal is input to the input terminal of the driving element and the relay coil is excited to switch a contact point of the switch element from the first node to the second node, the control terminal may be connected to the second node.

According to another embodiment, in response to the trigger signal input through the second node and the control terminal, the main switch may allow the electrical connection between the battery device and the power supply block and/or may trigger the operation of the power supply block. In other words, the main switch may be configured to perform the function described above.

According to another embodiment, as a state of the trigger signal input to the control terminal is released so that the contact point of the switch element is switched from the second node to the first node, the control terminal may be connected to the first node.

Yet another aspect of the present disclosure refers to a battery management system for managing a battery device provided with a thermal fuse block including one or more thermal fuses. The battery management system includes a power supply block configured to supply power for enabling the battery management system based on battery power applied from the battery device, an ignition block configured to enable or disable an electrical connection between the battery device and the power supply block and/or to control an operation trigger for the power supply block according to a status monitoring signal for the battery device generated according to a status of the thermal fuse block and a processor, which, in a state in which the battery device and the power supply block are electrically connected by the ignition block, is enabled by receiving operating power from the power supply block and monitors a status of the battery device.

According to one embodiment, the battery management system may further include a communication block, wherein the processor transmits a result of monitoring the status of the battery device to a high-level controller of a vehicle, in which the battery device is mounted, through the communication block. In other words, the processor and the communication block may be configured to perform the function described above.

According to another embodiment, independently of an operation of enabling or disabling the electrical connection between the battery device and the power supply block by the status monitoring signal, in response to a trigger signal applied from the high-level controller, the ignition block may allow the electrical connection between the battery device and the power supply block and/or may trigger the operation of the power supply block.

### 1. Structure of battery device

A battery device BAT described in the present embodiment may be a battery cell C, a battery module M, or a battery pack P. Prior to a detailed description of the present embodiment, first, the structure of the battery device BAT, which is a subject which is to be monitored and of which a status is to be determined, will be briefly described in the present embodiment.

### [Battery Module]

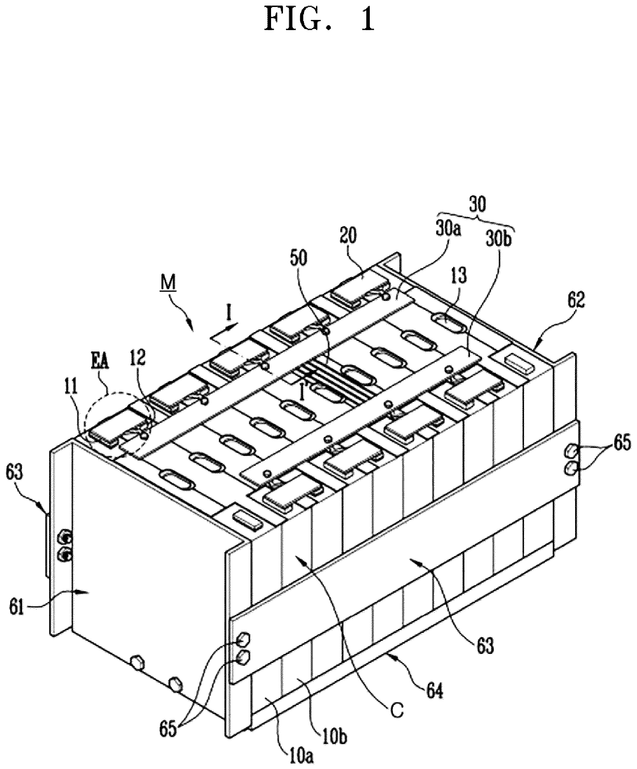

FIG. 1 is a perspective view illustrating the battery module M according to one embodiment of the present disclosure.

Referring to FIG. 1, the battery module M, according to the present disclosure, includes a plurality of battery cells C which include terminal portions 11 and 12 and are arranged in one direction, a connection tab 20 which connects a battery cell 10a and an adjacent battery cell 10b, and a protection circuit module 30 of which one end portion is connected to the connection tab 20. The protection circuit module 30 may be a battery management system (BMS). In addition, the connection tab 20 includes a body portion in contact with the terminal portions 11 and 12 between adjacent battery cells 10a and 10b, and an extension portion that extends from the body portion 22 and is connected to the protection circuit module 30. The connection tab 20 may be a busbar.

The battery cell C may include a battery case, and an electrode assembly and an electrolyte accommodated in the battery case. The electrode assembly and the electrolyte electrochemically react with each other to generate energy. The terminal portions 11 and 12 electrically connected to the connection tab 20 and a vent 13, which is a discharge passage for gas generated inside of the battery cell C, may be provided at one side of the battery cell C. The terminal portions 11 and 12 of the battery cell 10 may be a positive electrode terminal 11 and a negative electrode terminal 12 having different polarities. The terminal portions 11 and 12 of adjacent battery cells 10a and 10b may be electrically connected in series or parallel by the connection tab 20 to be described below. Meanwhile, although an example of serial connection has been described above, the present disclosure is not limited to such a structure, and of course, various connection structures can be adopted as needed. In addition, the number and arrangement of the battery cells C are not limited to the structure shown in FIG. 1 and may be changed as needed.

The plurality of battery cells C may be arranged in one direction such that wide surfaces of the battery cells C face each other, and the plurality of arranged battery cells C may be fixed by housings 61, 62, 63, and 64. The housings 61, 62, 63, and 64 may include a pair of end plates 61 and 62 facing the wide surfaces of the battery cells 10, and side plates 63 and a bottom plate 64 which connect the pair of end plates 61 and 62. The side plate 63 may support a side surface of the battery cell 10, and the bottom plate 64 may support a bottom surface of the battery cell 10. In addition, the pair of end plates 61 and 62, the side plate 63, and the bottom plate 64 may be connected by members such as bolts 65 or the like.

The protection circuit module 30 may be mounted with electronic components and protection circuits and may be electrically connected to the connection tab 20 to be described below. The protection circuit module 30 may include a first protection circuit module 30a and a second protection circuit module 30b that extend at different positions in a direction in which the plurality of battery cells C are arranged. In this case, the first protection circuit module 30a and the second protection circuit module 30b may be spaced a certain interval apart from each other, may be positioned parallel to each other, and may each be electrically connected to the connection tab 20 adjacent thereto. For example, the first protection circuit module 30a may be formed to extend at one upper side of the plurality of battery cells C in the direction in which the plurality of battery cells C are arranged, and the second protection circuit module 30b may be formed to extend at the other upper side of the plurality of battery cells C in the direction in which the plurality of battery cells C are arranged. The second protection circuit module 30b may be positioned to be spaced a certain interval apart from the first protection circuit module 30a with the vent 13 interposed therebetween and may be disposed parallel to the first protection circuit module 30a. In this way, two protection circuit modules are disposed in parallel and spaced apart from each other in the direction in which the plurality of battery cells C are arranged, thereby minimizing an area of a printed circuit board (PCB) constituting the protection circuit module. That is, the protection circuit module is provided as two separate protection circuit modules, thereby minimizing an unnecessary PCB area. The first protection circuit module 30a and the second protection circuit module 30b may be connected to each other by a conductive connection member 50. In this case, one side of the connection member 50 may be connected to the first protection circuit module 30a, and the other side thereof may be connected to the second protection circuit module 30b so that an electrical connection may be made between the two protection circuit modules.

The connection may be performed through any one method of soldering, resistance welding, laser welding, and projection welding methods.

The connection member 50 may be, for example, an electric wire. In addition, the connection member 50 may be made of an elastic or flexible material. Through the connection member 50, it is possible to check and manage whether the voltage, temperature, and current of the plurality of battery cells C are normal. That is, information about a voltage, a current, a temperature, or the like received by the first protection circuit module from the connection tabs adjacent thereto and information about a voltage, a current, a temperature, or the like received by the second protection circuit module from the connection tabs adjacent thereto may be integrally managed through the connection member 50 by the protection circuit module 30.

In addition, when the battery cell C swells, an impact is absorbed due to the elasticity or flexibility of the connection member 50, thereby preventing damage to the first and second protection circuit modules 30a and 30b.

In addition, the shape and structure of the connection member 50 are not limited to the shape shown in FIG. 1.

In this way, the protection circuit module 30 is provided as the first and second protection circuit modules 30a and 30b, the area of the PCB constituting the protection circuit module can be minimized, thereby securing a space inside the battery module M. Thus, a fastening operation of connecting the connection tab 20 and the protection circuit module 30 may be facilitated, and also a repair may be facilitated when an abnormality is detected in the battery module M, thereby improving operation efficiency.

### [Battery Pack]

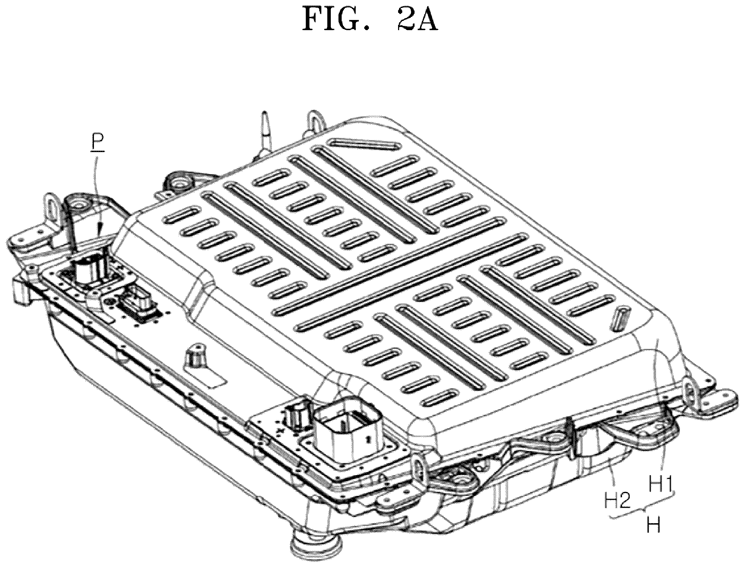

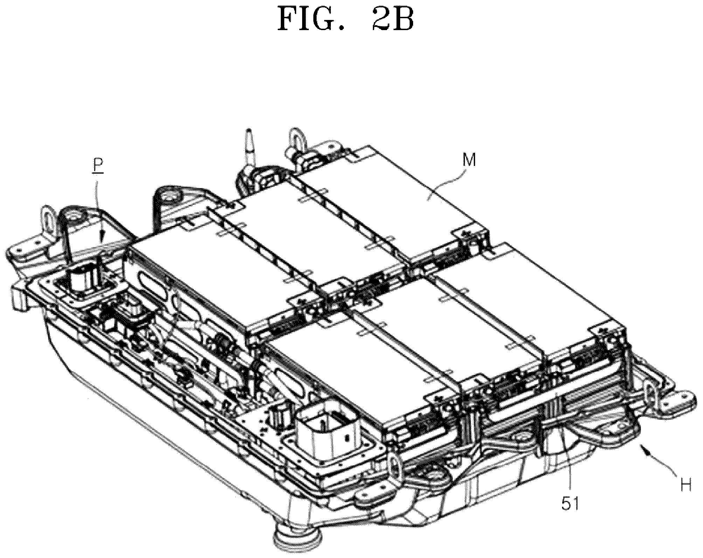

FIGS. 2A and 2B illustrate the battery pack P according to one exemplary embodiment of the present disclosure.

The battery pack P may include a plurality of battery modules M and a housing H for accommodating the plurality of battery modules M. For example, the housing H may include first and second housings H1 and H2 that are coupled to face each other with the plurality of battery modules M interposed therebetween. The plurality of battery modules M may be electrically connected to each other using a busbar 51, and the plurality of battery modules M may be electrically connected to each other in series, in parallel, or in a series-parallel combination scheme to obtain required electrical output power.

### 2. Apparatus for monitoring battery status

In order to detect abnormal operations such as thermal runaway or thermal propagation by detecting a temperature of the battery device BAT (which may be, for example, a high-voltage battery for driving an electric vehicle or a low-voltage battery such as a lead acid battery), there is a constraint in that a BMS should be in an enabled state (that is, a state of being enabled by receiving operating power). For example, when the ignition of a vehicle is turned on and an ignition signal is input to the BMS from a high-level controller 700 (for example, an electronic control unit (ECU)), an ignition circuit inside the BMS is enabled, and the enabled ignition circuit operates to convert an electrically disconnected state between the battery device BAT and a power supply circuit to an electrically connected state. As the power supply circuit is enabled, all integrated circuits (ICs) inside the BMS receive operating power from the enabled power supply circuit, and a processor 600 (for example, a micro controller unit (MCU)) of the BMS is also enabled to monitor a status of the battery device BAT, with the processor transmitting monitoring results to the high-level controller 700 of the vehicle.

A status monitoring operation for the battery device BAT as described above is based on a state in which an ignition signal is input from the high-level controller 700 of the vehicle to enable the BMS. When an ignition signal is not input from the high-level controller 700 of the vehicle so that the BMS is in a disabled state (that is, a sleep mode), the ignition circuit inside the BMS does not operate. Thus, the power supply circuit does not operate, and a processor 600 of the BMS is also maintained in a disabled state. Accordingly, the processor 600 cannot monitor a temperature of a battery cell or an air pressure inside the battery pack. Thus, an abnormal operation of the battery device BAT, such as thermal runaway or thermal propagation of the battery device BAT, cannot be detected.

The present embodiment proposes a monitoring and status determining topology in which, even in a state in which an ignition signal is not applied to the BMS from the high-level controller 700 of the vehicle (that is, in a disabled state of the BMS) a status of the battery device BAT may be monitored to defect abnormalities such as thermal runaway or thermal propagation. Hereinafter, a detailed description will be provided.

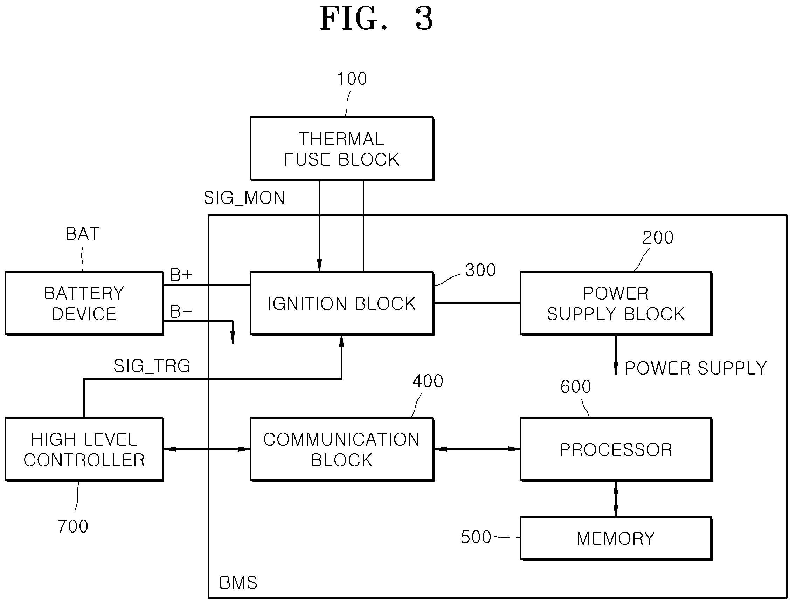

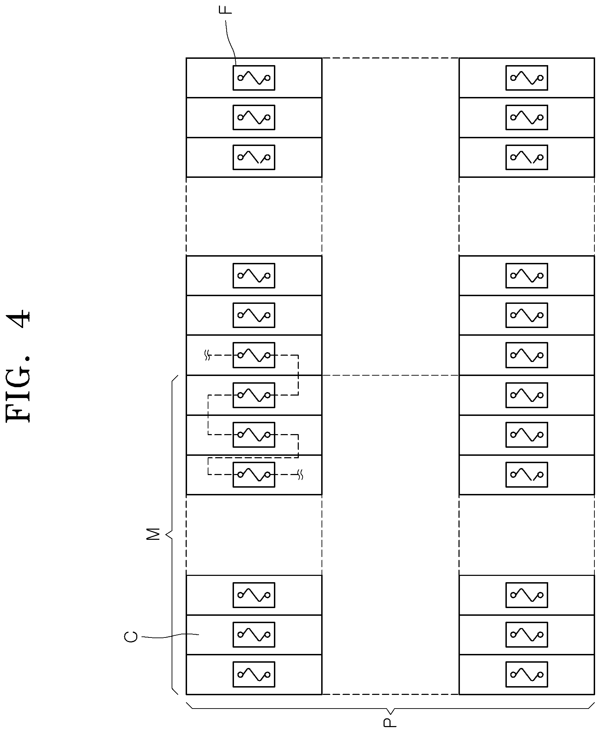

FIG. 3 is a block diagram of an apparatus for monitoring a battery status according to one embodiment of the present disclosure. FIG. 4 is an exemplary diagram of a wiring structure of a thermal fuse block according to one embodiment of the present disclosure. In FIG. 3, a voltage corresponding to "B+" may be the highest voltage or an intermediate voltage of a battery device BAT.

Referring to FIGS. 3 and 4, the apparatus for monitoring a battery status (hereinafter referred to as the apparatus) according to the present embodiment may include a thermal fuse block 100, a power supply block 200, an ignition block 300, a communication block 400, a memory 500, and a processor 600. The power supply block 200, the ignition block 300, the communication block 400, the memory 500, and the processor 600 may correspond to ICs inside a BMS as shown in FIG. 3.

The thermal fuse block 100 may include one or more thermal fuses F (or thermal cutoff fuses) provided in the battery device BAT, and as shown in FIG. 4, each thermal fuse F may be provided in a structure attached to a surface of a battery cell included in the battery device BAT (in order to clearly illustrate the structure, in FIG. 4, other components provided in the battery device BAT are omitted, and only the thermal fuses F are illustrated). As is well known in the art, the thermal fuse F operates such that, in a state in which a current flows from one lead to the other lead through a sliding contact and a metal case, when a surrounding temperature rises and reaches a melting temperature (melting point), the leads at both ends are condensed and disconnected (cut-off) by surface tension generated when a resin mixture (compound mixture) is liquefied. As described below, a fusing operation of the thermal fuse F causes a second signal level of a status monitoring signal SIG_MON to perform a function of electrically connecting the battery device BAT and the power supply block 200.

In the present embodiment, when the battery device BAT is defined as including first to N^{th} battery cells (N being a natural number of 2 or more), the thermal fuse F may be provided in each of the first to N^{th} battery cells or may be provided only in some battery cells (for example, the thermal fuse F is provided for every two or three battery cells). The number of battery cells equipped with the thermal fuses F and the arrangement structure thereof may be predesigned based on the characteristics and specifications of the battery device BAT and the designer's experimental results. When the arrangement structure of the thermal fuse block 100 is generalized, it may be expressed that M^{th} to K^{th} thermal fuses F are respectively provided in the M^{th} to K^{th} battery cells among the first to N^{th} battery cells (M being a natural number of 1 or more, K being a natural number of N or less, and M ≤ K).

The M^{th} to K^{th} thermal fuses F may be provided to be connected in series, and the series connection structure of the thermal fuses F may serve as a structure for generating a first signal level and a second signal level of a status monitoring signal SIG_MON (which will be described below).

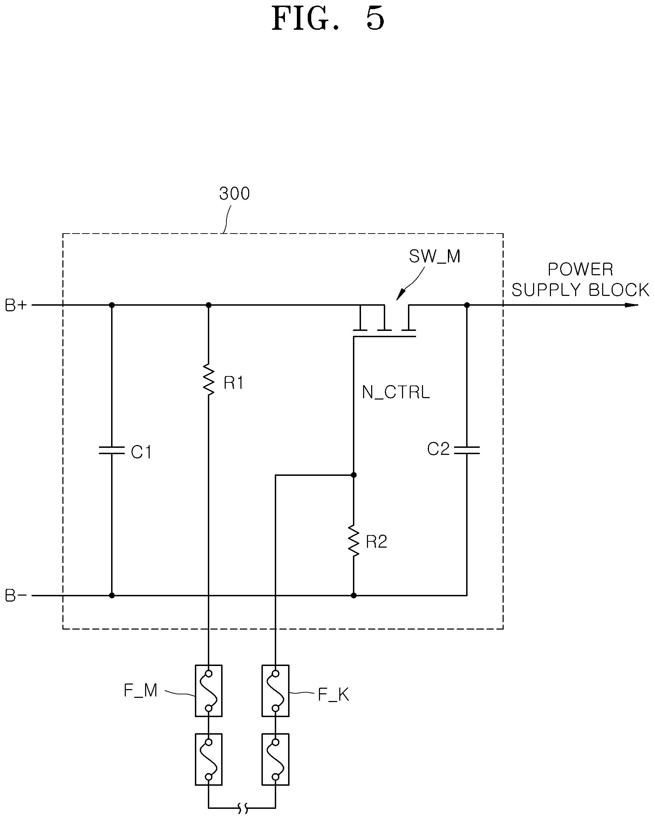

Among the thermal fuses F provided in the battery cells, the thermal fuses F positioned at ends (in the above example, M^{th} and K^{th} thermal fuses F_M and F_K) may be connected to the ignition block 300 which will be described below. For example, the M^{th} thermal fuse F_M may be connected to a node (node B+ in FIG. 5) of the ignition block 300, which is connected to a positive terminal B+ of the battery device BAT, and the K^{th} fuse may be connected to a control terminal (see N_CTRL in FIG. 5) of a main switch SW_M included in the ignition block 300 (hereinafter a node connected to the control terminal is referred to as a control node). Accordingly, a signal path is formed from the positive terminal of the battery device BAT to the M^{th} to K^{th} thermal fuses F, and the signal path becomes a path through which the status monitoring signal SIG_MON (which will be described below) is applied to the main switch SW_M. A detailed description thereof will be provided later with reference to FIG. 5.

Next, in a state in which the power supply block 200 is electrically connected to the battery device BAT by the ignition block 300 (which will be described below), the power supply block 200 may operate to generate and supply operating power for the ICs inside the BMS based on battery power applied from the battery device BAT, and the processor 600 (which will be described below) may also perform various operations of managing the battery device BAT based on operating power supplied from the power supply block 200. The power supply block 200 may be implemented as a converter or a power management integrated circuit (PMIC) that converts battery power into operating power (internal power or external power) used inside or outside the BMS.

The ignition block 300 may operate to enable or disable an electrical connection between the battery device BAT and the power supply block 200 or control an operation trigger for the power supply block. In the present embodiment, the ignition block 300 may correspond to an ignition circuit that operates to enable or disable the electrical connection between the battery device BAT and the power supply block 200 according to the status monitoring signal SIG_MON for the battery device BAT that is generated based on a status of the thermal fuse block 100. That is, independent (irrespective) of a trigger signal SIG_TRG (ignition signal) applied from a high-level controller 700 of a vehicle when the ignition of the vehicle is turned on, the ignition block 300 is configured to perform an operation of enabling or disabling the electrical connection between the battery device BAT and the power supply block 200 according to the status monitoring signal SIG_MON for the battery device BAT.

FIG. 5 illustrates one embodiment of a circuit structure of the ignition block 300. As shown in FIG. 5, the ignition block 300 may include the main switch SW_M that directly enables or disables the electrical connection between the battery device BAT and the power supply block 200. FIG. 5 illustrates an example in which the main switch SW_M is implemented as a p-channel field effect transistor (FET). However, the main switch SW_M may be implemented as one of various circuit elements (for example, a bipolar junction transistor (BJT), a low-power comparator, and a low-power ignition IC). Hereinafter, for a better understanding of the embodiment, an example in which the main switch SW_M is the p-channel FET will be described. Meanwhile, the ignition block 300 may additionally further include a noise removal capacitor C1 for removing noise of battery power input from the battery device BAT, an output capacitor C2 for outputting battery power, and a noise removal capacitor C2 for outputting battery power, a first tuning resistor R1 connected between the positive terminal of the battery device BAT and the thermal fuse block 100, and a second tuning resistor R2 connected between a negative terminal B- of the battery device BAT and a connection node (that is, a control node N_CTRL) between the thermal fuse block 100 and a control terminal of the main switch SW_M.

As shown in FIG. 5, a signal path, which is connected from the positive terminal of the battery device BAT to the thermal fuse block 100 (specifically, the M^{th} to K^{th} thermal fuses F respectively disposed in the M^{th} to K^{th} battery cells), is provided, and the signal path becomes a path through which the status monitoring signal SIG_MON for the battery device BAT is applied to the control terminal of the main switch SW_M. In this case, a signal level of the status monitoring signal SIG_MON may be differentially generated according to a status of a signal path determined based on whether the M^{th} to K^{th} thermal fuses F are fused.

In a state in which each battery cell included in the battery device BAT is not overheated, that is, in a normal state in which the M^{th} to K^{th} thermal fuses F are not fused, a current signal having a certain magnitude flows from the positive terminal of the battery device BAT to the M^{th} to K^{th} thermal fuses F (the magnitude of the current signal depends on a resistance value of the first tuning resistor R1 and an internal resistance value of the M^{th} to K^{th} thermal fuses F). A voltage signal having a certain magnitude is generated in the control node N_CTRL by the current signal generated as described above and the second tuning resistor R2, and the voltage signal generated as described above is applied to the control terminal of the main switch SW_M as the status monitoring signal SIG_MON. Accordingly, the main switch SW_M corresponding to the p-channel FET is turned off (opened) to disable the electrical connection between the battery device BAT and the power supply block 200.

That is, in a state in which the M^{th} to K^{th} thermal fuses F are not fused, the status monitoring signal SIG_MON (signal generated in the control node N_CTRL) may have a first signal level (high-level), and when the status monitoring signal SIG_MON having the first signal level is applied, the ignition block 300 may be configured to disable the electrical connection between the battery device BAT and the power supply block 200 or to not trigger the operation of the power supply block 200 through a turn-off operation of the main switch SW_M.

When some of the battery cells in the battery device BAT are overheated, a surface temperature of the battery cells abruptly rises, and when the surface temperature of the battery cells reaches a melting temperature of the thermal fuse F, the thermal fuse F is fused (cut off). Accordingly, in an abnormal state in which one or more of the M^{th} to K^{th} thermal fuses F are fused, the positive terminal of the battery device BAT and the control terminal of the main switch SW_M are not electrically connected due to the fused thermal fuses F, and the control terminal of the main switch SW_M is connected (that is, grounded) to a negative terminal of a battery. Accordingly, a ground signal (that is, a zero voltage) is generated in the control node N_CTRL, and the ground signal generated as described above is applied to the control terminal of the main switch SW_M as the status monitoring signal SIG_MON for the battery device BAT. Accordingly, the main switch SW_M corresponding to the p-channel FET is turned on (closed), and thus the battery device BAT and the power supply block 200 are electrically connected.

That is, in a state in which the M^{th} to K^{th} thermal fuses F are fused, the status monitoring signal SIG_MON (signal generated in the control node N_CTRL) may have a second signal level (low level), and when the status monitoring signal SIG_MON having the second signal level is applied, the ignition block 300 may allow the electrical connection between the battery device BAT and the power supply block 200 or trigger the operation of the power supply block 200 through a turn-on operation of the main switch SW_M.

As can be seen from the above description, independent (irrespective) of the trigger signal SIG_TRG (ignition signal) applied from the high-level controller 700 of the vehicle when the ignition of the vehicle is turned on, the ignition block 300 may be configured to perform an operation of enabling or disabling the electrical connection between the battery device BAT and the power supply block 200 according to the status monitoring signal SIG_MON for the battery device BAT. This means that even in a state in which the trigger signal SIG_TRG is not applied from the high-level controller 700 of the vehicle, when an abnormality of the battery device BAT is detected by the thermal fuse block 100 provided in the battery device BAT, the BMS may be enabled. Thus, a status of the battery device BAT may be monitored at all times irrespective of whether the trigger signal SIG_TRG is applied from the high-level controller 700 of the vehicle. Accordingly, defects such as thermal runaway or thermal propagation of the battery device BAT may be monitored at all times, thereby preventing defects of the battery device BAT in advance.

The memory 500 may store at least one instruction executed by the processor 600 (which will be described below) and also store a status determination logic for supporting a status determination operation for the battery device BAT that is executed by the processor 600. The status determination logic may correspond to, for example, a logic that determines that defects of the battery device BAT occurs when a temperature or pressure of the battery device BAT is greater than or equal to a preset reference value of each of the temperature and the pressure. The memory 500 may be implemented as a volatile storage medium and/or a non-volatile storage medium, for example, as a read-only memory (ROM) and/or a random access memory (RAM).

The processor 600 may be controlled to be enabled or disabled according to whether one or more of the M^{th} to K^{th} thermal fuses F is fused, and in an enabled state, the processor 600 may perform a status monitoring operation and a status determination operation for the battery device BAT. The processor 600 may be implemented as a central processing unit (CPU) or a system-on-chip (SoC), drive an operating system or application to control a plurality of hardware or software components connected to the processor 600, and process various pieces of data and perform calculations. The processor 600 may be configured to execute at least one instruction stored in the memory 500 and store execution result data in the memory 500.

In the present embodiment, the processor 600 may correspond to the MCU of the BMS that monitors the current, voltage, temperature, and pressure of the battery device BAT and controls and manages the battery device BAT based on the monitoring results. In order to support the operation of the processor 600, the battery device BAT may include a current sensor, a voltage sensor, a temperature sensor, and a pressure sensor for respectively detecting the current, voltage, temperature, and pressure of the battery device BAT. The sensors may be provided at certain positions within a range in which the current, voltage, temperature, and pressure of the battery device BAT may be detected.

In a state in which the M to K thermal fuses F are not fused, that is, in a state in which the electrical connection between the battery device BAT and the power supply block 200 is disabled through a turn-off operation of the main switch SW_M of the ignition block 300, the power supply block maintains a disabled state, and thus the BMS maintains a disabled state. Accordingly, the processor 600 does not perform a status monitoring operation for the battery device BAT.

In a state in which one or more of the M to K thermal fuses F is fused, that is, in a state in which the battery device BAT and the power supply block are electrically connected through a turn-on operation of the main switch SW_M of the ignition block 300, as the power supply block 200 is enabled, each IC inside the BMS is also enabled, and the processor 600 also receives operating power from the power supply block 200 to perform a status monitoring operation for the battery device BAT. In this case, the processor 600 may determine a status of the battery device BAT according to the state determination logic predefined in the memory 500. The processor 600 may transmit status monitoring results and status determination results of the battery device BAT to the high-level controller 700 of the vehicle through the communication block 400 (for example, a controller area network (CAN) transceiver).

### 3. Operation of ignition block by trigger signal and status monitoring signal

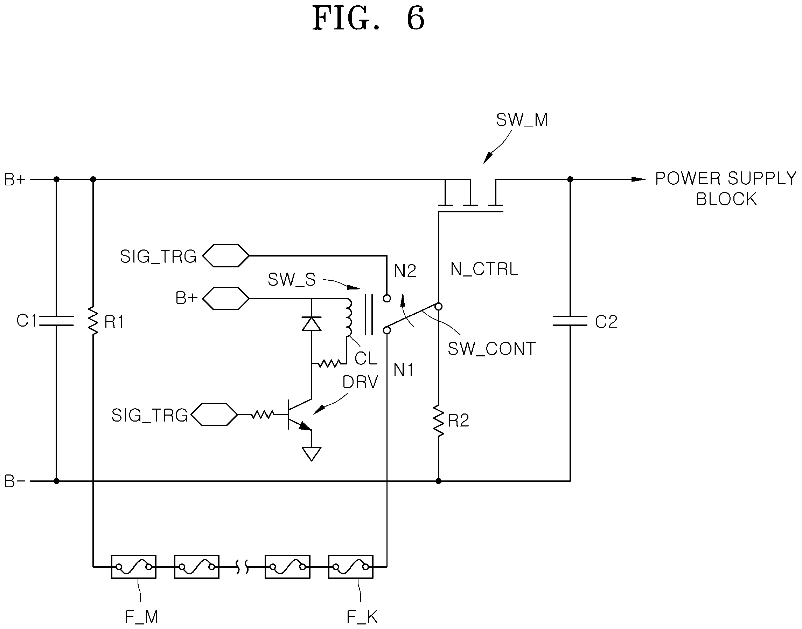

Above, a configuration in which the operation of the ignition block 300 is controlled according to the status monitoring signal SIG_MON has been described based on the circuit structure of the ignition block 300 shown in FIG. 5. The operation of the ignition block 300 according to the status monitoring signal SIG_MON as described above may be implemented in conjunction with the operation of the ignition block (that is, an ignition circuit) according to a trigger signal, which is already applied to the vehicle. Hereinafter, a method in which the operation of the ignition block according to the status monitoring signal is in conjunction with the operation of the ignition block according to the trigger signal will be described in detail based on a circuit configuration of the ignition block 300 of FIG. 6. All configurations of the present embodiment described above are equally applied hereunder. For reference, the ignition block 300 described in the present embodiment is a component corresponding to an ignition circuit of a BMS.

Referring to FIG. 6, as compared with FIG. 5, the ignition block 300 may further include a sub-switch SW_S and a driving element DRV in addition to the main switch SW_M.

The sub-switch SW_S may selectively connect a control terminal for controlling the on/off operation of the main switch SW_M to a first node N1 and a second node N2. Here, the first node N1 is defined as a node connected to the K^{th} thermal fuse F_K of the thermal fuse block 100 (that is, the thermal fuse F positioned at an end negative terminal rather than the positive terminal of the battery device BAT). In the present embodiment, the sub-switch SW_S may be implemented as a relay including a relay coil CL of which one terminal, in other words first terminal, is connected to the positive terminal of the battery device BAT, and a switch element SW_CONT which performs a contact switching operation according to the excitation of the relay coil CL.

The driving element DRV may drive a switching operation of the sub-switch SW_S. The driving element DRV may be implemented as an NPN-type BJT including a driving terminal, which is connected to the other terminal, in other words second terminal, of the relay coil CL (that is, a terminal other than a terminal connected to the positive terminal of the battery device BAT) as a collector terminal, a ground terminal, which is connected to the ground, as an emitter terminal, and an input terminal, to which the trigger signal SIG_TRG is input from the high-level controller 700 of the vehicle, as a base terminal. That is, the driving element DRV functions as a low-side driver of the sub-switch SW_S.

The sub-switch SW_S may be provided to connect a control node N_CTRL to the first node N1 as a normal state. That is, in a state in which the trigger signal SIG_TRG is not applied from the high-level controller 700 of the vehicle through the second node N2, the sub-switch SW_S may be configured to connect the control node N_CTRL to the first node N1. Accordingly, in a state before the trigger signal SIG_TRG is applied from the high-level controller 700 of the vehicle, that is, in a time section before the ignition of the vehicle is turned on, the ignition block 300 may operate to enable or disable the electrical connection between the battery device BAT and the power supply block 200 according to a status monitoring signal input to the control terminal through the second node N2. This has been described above, and thus a detailed description thereof will be omitted.

When the ignition of the vehicle is turned on, the trigger signal SIG_TRG having a high-level is input from the high-level controller 700 to an input terminal of the driving element DRV. Thus, the driving element DRV is turned on. Accordingly, the sub-switch SW_S of the relay coil CL is excited, and a contact point of the switch element SW_CONT of the sub-switch SW_S is switched from the first node N1 to the second node N2. Accordingly, the control node N_CTRL may be connected to the second node N2, and the main switch SW_M may be configured to electrically connect the battery device BAT and the power supply block 200 in response to the trigger signal SIG_TRG input to the control terminal through the second node N2.

Thereafter, when the ignition of the vehicle is turned off and a state of the trigger signal SIG_TRG input to the control terminal of the main switch SW_M is released, the contact point of the switch element SW_CONT of the sub-switch SW_S is switched from the second node N2 to the first node N1. Thus, the control terminal of the main switch SW_M is connected to the first node N1. As a result, a state is returned to a state in which the regulation of the electrical connection between the battery device BAT and the power supply block 200 is controlled by the status monitoring signal SIG_MON.

Through the above-described configuration, i) in a state before the ignition of the vehicle is turned on, that is, in a time section in which the trigger signal SIG_TRG is applied from the high-level controller 700 of the vehicle, the electrical connection between the battery device BAT and the power supply block 200 may be enabled or disabled according to the status monitoring signal SIG_MON, and ii) when the ignition of the vehicle is turned on, a circuit mechanism is provided to allow the electrical connection between the battery device BAT and the power supply block 200 in response to the trigger signal SIG_TRG applied from the high-level controller 700. Thus, the operation of the ignition block according to the status monitoring signal may be in conjunction with the operation of the ignition block according to the trigger signal.

The present disclosure overcomes the conventional limitation that a status of a battery device is monitored only when an ignition signal is applied to a BMS from a high-level controller of a vehicle to enable the BMS. Even in a state in which an ignition signal is not received from a high-level controller of a vehicle, when an abnormality of a battery device is detected by a thermal fuse block 100 provided in the battery device, the circuit topology enables a BMS such that a status of the battery device can be monitored at all times irrespective of whether an ignition signal is applied from the high-level controller of the vehicle and whether the BMS is enabled. Thus monitoring for abnormalities such as thermal runaway or thermal propagation of the battery device is enabled at all times, and defects of the battery device may be prevented.

However, effects that can be achieved through the present disclosure are not limited to the above-described effects and other effects that are not described may be clearly understood by those skilled in the art from the detailed descriptions.

As used herein, the term "block" may include a unit implemented in hardware, software, or firmware, and may be used interchangeably with terms, for example, logic, logic block, component, or circuit. A "block" may be an integrally formed part or a minimal unit or portion of the part that performs one or more functions. For example, according to one embodiment, the "block" may be implemented in the form of an Application-Specific Integrated Circuit (ASIC). In addition, the embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the technical spirit of the present disclosure and the claims and their equivalents.

## Claims

1. An apparatus for monitoring a battery status, the apparatus comprising:
an ignition block (300) configured to enable or disable an electrical connection between a battery device (BAT) and a power supply block (200) mounted in a vehicle, the power supply block (200) being configured to supply operating power for managing the battery device (BAT) to a processor (600) based on battery power applied from the battery device (BAT); and
a thermal fuse block (100) including one or more thermal fuses (F_M, F_K, F) provided in the battery device (BAT),
wherein, according to a status monitoring signal (SIG_MON) for the battery device (BAT) generated according to a status of the thermal fuse block (100), the ignition block (300) is configured to perform an operation (i) to enable or disable the electrical connection between the battery device (BAT) and the power supply block (200) and/or (ii) to control an operation trigger for the power supply block (200).

2. The apparatus of claim 1, wherein the battery device (BAT) includes first to N^{th} battery cells (C, 10a, 10b), with N being a natural number of 2 or more,
wherein the thermal fuse block (100) includes M^{th} to K^{th} thermal fuses (F_M, F _K, F) respectively provided in M^{th} to K^{th} battery cells (C, 10a, 10b) among the first to N^{th} battery cells (C, 10a, 10b), with M being a natural number of 1 or more, and K being a natural number of N or less, and M ≤ K, and
wherein the M^{th} to K^{th} thermal fuses (F_M, F_K, F) are connected in series.

3. The apparatus of claim 2, wherein a signal level of the status monitoring signal (SIG_MON) is generated according to a status of a signal path connected from one terminal (B+) of the battery device (BAT) to the M^{th} to K^{th} thermal fuses (F_M, F_K, F).

4. The apparatus of claim 3, wherein,
in a state in which the M^{th} to K^{th} thermal fuses (F_M, F_K, F) are not fused, the status monitoring signal (SIG_MON) has a first signal level, and wherein, when the status monitoring signal (SIG_MON) having the first signal level is applied, the ignition block (300) is configured to disable the electrical connection between the battery device (BAT) and the power supply block (200) and/or to not trigger the operation of the power supply block (200), and/or wherein,
when one or more of the M^{th} to K^{th} thermal fuses (F_M, F_K, F) is fused, the status monitoring signal has a second signal level, and wherein, when the status monitoring signal having the second signal level is applied, the ignition block (300) is configured to enable the electrical connection between the battery device (BAT) and the power supply block (200) and/or to trigger the operation of the power supply block (200).

5. The apparatus of any one of claims 1 to 4, wherein, when the battery device (BAT) and the power supply block (200) are electrically connected so that the power supply block (200) is enabled, and when the operating power is supplied to the processor (600), the processor (600) is configured to determine a status of the battery device (BAT) according to a predefined state determination logic.

6. The apparatus of any one of claims 1 to 5, wherein, in a state in which the electrical connection between the battery device (BAT) and the power supply block (200) is disabled, in response to a trigger signal (SIG_TRG) applied from a high-level controller (700) applied to the vehicle, the ignition block (300) is configured to enable the electrical connection between the battery device (BAT) and the power supply block (200) and/or to trigger the operation of the power supply block (200).

7. The apparatus of claim 6, wherein, independent of the trigger signal (SIG_TRG), according to the status monitoring signal (SIG_MON), the ignition block (300) is configured to perform the operation of enabling or disabling the electrical connection between the battery device (BAT) and the power supply block (200) and/or an operation of controlling the operation trigger for the power supply block (200).

8. The apparatus of claim 7, wherein, in a state in which an ignition of the vehicle is turned on, in a time section before the trigger signal (SIG_TRG) is applied from a high-level controller (700), according to the status monitoring signal (SIG_MON), the ignition block (300) is configured to enable or disable the electrical connection between the battery device (BAT) and the power supply block (200) and/or to control the operation trigger for the power supply block (200), and
wherein, when the ignition of the vehicle is turned on, in response to the trigger signal (SIG_TRG) applied from the high-level controller (700), the ignition block (300) is configured to enable the electrical connection between the battery device (BAT) and the power supply block (200) and/or to trigger the operation of the power supply block (200).

9. An ignition circuit for a battery management system, the ignition circuit comprising:
a main switch (SW_M) configured to enable or disable an electrical connection between a battery device (BAT) and a power supply block (200) mounted in a vehicle; and
a sub-switch (SW_S) configured to selectively connect a control terminal for controlling an on/off operation of the main switch (SW_M) to a first node (N1) and a second node (N2), wherein the first node (N1) is a node connected to a thermal fuse block (100) including one or more thermal fuses (F_M, F_K, F) provided in the battery device (BAT), and the second node (N2) is a node connected to a high-level controller (700) applied to the vehicle,
wherein, in a state in which a trigger signal (SIG_TRG) is not applied from the high-level controller (700) through the second node (N2), the sub-switch (SW_S) is configured to connect the control terminal to the first node (N1).

10. The ignition circuit of claim 9, wherein, in a state in which the control terminal is connected to the first node (N1) through the sub-switch (SW_S), the main switch (SW_M) receives a status monitoring signal (SIG_MON) for the battery device (BAT), which is generated according to a status of the thermal fuse block (100), through the control terminal, and
wherein, according to the received status monitoring signal (SIG_MON), the main switch (SW_M) is configured (i) to enable or disable the electrical connection between the battery device (BAT) and the power supply block (200) and/or (ii) to control an operation trigger for the power supply block (200).

11. The ignition circuit of claim 10, wherein,
in a state in which each thermal fuse (F_M, F_K, F) included in the thermal fuse block (100) is not fused, the status monitoring signal (SIG_MON) has a first signal level, and wherein, when the status monitoring signal (SIG_MON) having the first signal level is input through the control terminal, the main switch (SW_M) is configured to disable the electrical connection between the battery device (BAT) and the power supply block (200) and/or not trigger the operation of the power supply block (200), and/or wherein,
in a state in which at least one thermal fuse (F_M, F_K, F) among the thermal fuses (F_M, F_K, F) included in the thermal fuse block (100) is fused, the status monitoring signal (SIG_MON) has a second signal level, and wherein, when the status monitoring signal (SIG_MON) having the second signal level is input through the control terminal, the main switch (SW_M) is configured to enable the electrical connection between the battery device (BAT) and the power supply block (200) and/or to trigger the operation of the power supply block (200).

12. The ignition circuit of any one of claims 9 to 11, wherein the sub-switch (SW_S) is implemented as a relay including a relay coil (CL) of which a first terminal is connected to the battery device (BAT) and a switch element (SW_CONT) configured to perform a contact switching operation according to excitation of the relay coil (CL),
wherein the ignition circuit includes a driving element (DRV) configured to drive a switching operation of the sub-switch (SW_S), and
wherein the driving element (DRV) includes a driving terminal connected to a second terminal of the relay coil (CL), a ground terminal connected to a ground, and an input terminal to which the trigger signal (SIG_TRG) is input.

13. The ignition circuit of claim 12, wherein, as the trigger signal (SIG_TRG) is input to the input terminal of the driving element (DRV) and the relay coil (CL) is excited to switch a contact point of the switch element (SW_CONT) from the first node (N1) to the second node (N2), the control terminal is connected to the second node (N2), wherein,
in response to the trigger signal (SIG_TRG) input through the second node (N2) and the control terminal, the main switch (SW_M) is configured to allow the electrical connection between the battery device (BAT) and the power supply block (200) and/or to trigger an operation of the power supply block (200), and/or wherein,
as a state of the trigger signal (SIG_TRG) input to the control terminal is released so that the contact point of the switch element (SW_CONT) is switched from the second node (N2) to the first node (N1), the control terminal is connected to the first node (N1).

14. A battery management system for managing a battery device (BAT) provided with a thermal fuse block (100) including one or more thermal fuses (F_M, F _K, F), the battery management system comprising:
a power supply block (200) configured to supply power for enabling the battery management system based on battery power applied from the battery device (BAT);
an ignition block (300) that, according to a status monitoring signal (SIG_MON) for the battery device (BAT) generated according to a status of the thermal fuse block (100), is configured to (i) enable or disable an electrical connection between the battery device (BAT) and the power supply block (200) and/or (ii) to control an operation trigger for the power supply block (200); and
a processor (600) that, in a state in which the battery device (BAT) and the power supply block (200) are electrically connected by the ignition block (300), is enabled by receiving operating power from the power supply block (200) and monitors a status of the battery device (BAT).

15. The battery management system of claim 14, further comprising a communication block (400),
wherein the processor (600) is configured to transmit a result of monitoring the status of the battery device (BAT) to a high-level controller (700) of a vehicle, in which the battery device (BAT) is mounted, through the communication block (400).
